# EUROPEAN PATENT APPLICATION

(11) **EP 1 939 775 A2**
(43) Date of publication of application: **02.07.2008**
(21) Application number: 07025033.7
(22) Date of filing: 21.12.2007
(51) Int. Cl.: G06F 17/50, H01L 31/00

(54) **Support system and program for installing photovoltaic power generator**

(30) Priority: 28.12.2006 JP 2006356078
(71) Applicant: Sharp Kabushiki Kaisha, Osaka-shi, Osaka 545-8522 (JP)
(72) Inventor: Suga, Yoshikazu, Sakai-shi, Osaka 591-8001 (JP); Ishikawa, Kazuhiko, Yamatokoriyama-shi, Nara 639-1042 (JP)
(74) Representative: Müller - Hoffmann & Partner

(57) **Abstract**

A support system for installing a photovoltaic power generator includes: display means for displaying an installation surface image including an installation surface on which photovoltaic modules are to be installed and a gauge disposed on the installation surface and whose actual dimensions are known, the installation surface being a region of a finite area; installation surface input means for receiving inputs for specifying the installation surface on the installation surface image displayed on the display means; installation surface shape specification means for specifying an installation surface shape on the basis of the dimensions of the gauge in the installation surface image; and module determination means for determining a type and layout of the photovoltaic modules suitable for the installation surface shape.

## Description

### BACKGROUND OF THE INVENTION

### Field of the Invention

The present invention relates to a support system and program for installing a photovoltaic power generator, which can facilitate estimation of installation cost of the photovoltaic power generator.

### Description of Related Art

In recent years, utilization of various energies has been reconsidered in view of taking measures for global environment such as reduction of CO₂. Particularly, solar cells which utilize solar energy have been expected to be representatives of environment-friendly and clean energy supply sources. In general, photovoltaic power generators are designed to be distributed power supplies which interconnect with a commercial power supply such that electricity is supplied from the commercial power supply of the system in the case where the required electricity consumption can not be covered by only the distributed power supply. Also, in the case where the electricity generated by the solar cells becomes redundant, the photovoltaic power generator can supply electricity to the interconnected commercial power supply, namely it can sell the electricity, which facilitates recovering of installation and maintenance cost of the generator. This has contributed to installation of photovoltaic power generators to the roofs of ordinary houses. Consequently, it is important for customers who possess photovoltaic power generators installed on their houses to efficiently recover the cost and time consumed for installing the photovoltaic power generators and the cost and labor consumed for maintenance of the photovoltaic power generators, in the form of generated electric power. Therefore, it has been necessary to perform diagnostics for determine whether or not the output of the photovoltaic power generator is normal at the time of the installation thereof and, if it is abnormal, it has been necessary to accurately and rapidly perform diagnostics of the cause thereof. For example, there is a diagnosis method performed after installation of a photovoltaic power generator as disclosed in JP-A 2001-326375.

However, potential customers who have not possessed a photovoltaic power generator regard, as important, information about the electric power generation amount of a photovoltaic power generator to be installed, information as to which surface should be used for installation for providing a greatest efficiency in cases where the roof has different shapes and orientations and information about the purchase/installation costs and the like. In order to obtain such information, it has been necessary to perform works of measuring the roof shape, performing estimation of the area thereof, determining the concrete layout and the like of photovoltaic modules and creating the specifications of the photovoltaic power generator. Particularly, potential customers do not necessarily have drawings of their own houses and, therefore, salespersons have been required to visit customer's houses, measure and inspect their roof shapes by climbing on the roofs; suggest specification drafts such as the installation layout and the like and concrete drafts such as the estimated prices and also suggest economic simulations of calculations of the balance between the customer's electric power consumption and electric power generation amount as required for facilitating the customer's motivations for installation for winning contracts. As described above, such conventional methods require visiting customer's houses a number of times at the steps of "proposing", "measurement and inspection", "suggestion of specification drafts, estimation and economic simulations" and "contract". This requires adding the costs required for such visiting investigations and the like at the actual places, such as personnel costs, to the installation cost for photovoltaic power generators.

In some cases, a salesperson visiting a potential customer is requested to present initial investment cost and perform an economical simulation in order to motivate the potential customer. It is not a rare case that a salesperson visits a potential customer multiple times to create new document each time a plan is reviewed. In the cases where the installation of a photovoltaic power generator is not realized after multiple visits, the personal expense costs required for the investigation put pressure on the profits. This causes salespersons to have feelings of resistance toward making concrete suggestions to new potential customers, thereby disturbing facilitation of installations of photovoltaic power generators. Accordingly, currently, in order to develop new potential customers, salespersons have relied on passive sales responsive to actions from customers who desire photovoltaic power generators, sales using advertising catalogs or phones, visiting sales using pamphlets, holding of events or the like. These visiting sales, holding of events or the like have problems of impossibility of obtaining information about roof shapes of customer's houses and suggesting estimation, which makes impossible to make concrete suggestions appropriate to respective potential customers, thereby resulting in one-sided sales and insufficient motivation to installation of photovoltaic power generators. Therefore, eventually, it is necessary to rely on salespersons' efforts to repeatedly visit potential customers many times, thereby requiring a long time until installation as well as costs.

Namely, the manufacturers of photovoltaic power generators also have desired to easily acquire, prior to installation, concrete data about the electric power generation amount, the installation cost and the like as the photovoltaic power generator installation plan and also suggest such data to potential customers. Consequently, there has been a need for a support system for installing a photovoltaic power generator which enables suggesting concrete drafts and giving sufficient explanation to potential customers with some on-site inspections, causes customers to have motivations and secure feeling for installation and enables facilitation of installation of photovoltaic power generators. Further, there has been no simple and effective information collecting means for potential customers who do not know actual prices such as the installation costs and actual power generation amount and thus require a long time for determining the purchase of photovoltaic power generators while having awareness about photovoltaic generation. Therefore, there has been a need for such a support system for installing a photovoltaic power generator.

### SUMMARY OF THE INVENTION

The present invention has been made in view of the aforementioned circumstances and aims to provide a support system for installing a photovoltaic power generator, capable of promptly and easily determining the type and layout of photovoltaic modules adapted to the shape of an installation surface.

According to the present invention, a support system for installing a photovoltaic power generator includes: display means for displaying an installation surface image including an installation surface on which photovoltaic modules are to be installed and a gauge disposed on the installation surface and whose actual dimensions are known, the installation surface being a region of a finite area; installation surface input means for receiving inputs for specifying an installation surface on the installation surface image displayed on the display means; installation surface shape specification means for specifying an installation surface shape on the basis of the dimensions of the gauge in the installation surface image; and module determination means for determining a type and layout of the photovoltaic modules suitable for the installation surface shape.
In the system of the present invention, the installation surface shape is determined by using an image including the installation surface of photovoltaic modules and a gauge disposed on the installation surface and whose actual dimension is known. Consequently, without actually measuring the dimensions of the installation surface, the installation surface shape can be promptly and easily specified. Since the module determination means determines the type and layout of the photovoltaic module suitable for the installation surface shape, by using the system of the present invention, the type and layout of the photovoltaic module suitable for the installation surface shape can be promptly and easily determined.

The system of the present invention can further include estimation means for calculating estimated price for installation of a photovoltaic power generator on the basis of the type and layout of the photovoltaic module determined by the module determination means. In this case, the estimated price for installation of a photovoltaic power generator can be calculated promptly and easily.

### BRIEF DESCRIPTION OF THE DRAWINGS

The present invention will become more fully understood from the detailed description given hereinbelow and the accompanying drawings which are given by way of illustration only, and thus are not limitative of the present invention and wherein:
Figs. 1A and 1B illustrate a method for capturing an installation surface image, of a support system for installing a photovoltaic power generator as an embodiment of the present invention;
Fig. 2 is a plan view illustrating a gauge of color allocation for clear weather, of the system as the embodiment of the present invention;
Fig. 3 is a plan view illustrating a gauge of color allocation for cloudy weather, of the system as the embodiment of the present invention;
Figs. 4A and 4B are a plan view and a front view, respectively, showing a gauge to which non-slip members are attached, of the system as the embodiment of the present invention;
Fig. 5 is a perspective view illustrating an exemplary installation of a photovoltaic power generator, of the system as the embodiment of the present invention;
Fig. 6 is a perspective view for explaining a method of specifying an installation surface shape, of the system as the embodiment of the present invention;
Fig. 7 is a perspective view for explaining a method of specifying the installation surface shape, of the system as the embodiment of the present invention;
Fig. 8 illustrates an example of a display screen for explaining a layout method of modules, of the system as the embodiment of the present invention;
Fig. 9 illustrates an example of the display screen for explaining a layout method of modules, of the system as the embodiment of the present invention;
Fig. 10 illustrates an example of the display screen for explaining a layout method of modules, of the system as the embodiment of the present invention;
Fig. 11 is a configuration diagram of the system as First Example of the present invention;
Fig. 12 shows an example of an input screen of the system as the First Example of the present invention;
Fig. 13 illustrates a synthesized image showing an exemplary installation of a photovoltaic power generator, in the system as the First Example of the present invention;
Fig. 14 shows an example of an output screen of the system as the First Example of the present invention;
Fig. 15 is a configuration diagram of a system as Second Example of the present invention;
Fig. 16 illustrates an example of an estimation completion mail in the system as the Second Example of the present invention;
Fig. 17 is a configuration diagram of a system as Third Example of the present invention;
Fig. 18 is a configuration diagram of a system as Fourth Example of the present invention;
Fig. 19 is a configuration diagram of a system as Fifth Example of the present invention;
Fig. 20 illustrates an example of a display screen in the systems of the First to Fifth Examples of the present invention;
Fig. 21 illustrates an example of the display screen in the systems of the First to Fifth Examples of the present invention;
Fig. 22 illustrates an example of the display screen in the systems of the First to Fifth Examples of the present invention;
Fig. 23 illustrates an example of the display screen in the systems of the First to Fifth Examples of the present invention;
Fig. 24 illustrates an example of the display screen in the systems of the First to Fifth Examples of the present invention;
Fig. 25 illustrates an example of the display screen in the systems of the First to Fifth Examples of the present invention;
Fig. 26 illustrates an example of the display screen in the systems of the First to Fifth Examples of the present invention;
Fig. 27 illustrates an example of the display screen in the systems of the First to Fifth Examples of the present invention;
Fig. 28 illustrates an example of an estimation sheet in the systems of the First to Fifth Examples of the present invention;
Fig. 29 illustrates an example of the display screen in the systems of the First to Fifth Examples of the present invention;
Fig. 30 illustrates an example of a proposal in the systems of the First to Fifth Examples of the present invention;
Fig. 31 illustrates an example of a proposal in the systems of the First to Fifth Examples of the present invention; and
Fig. 32 is a conceptual diagram showing the relations among a leasing company, a system operating company, and a dealer, in a system as an embodiment of the present invention.

### DESCRIPTION OF THE PREFERRED EMBODIMENTS

A support system for installing a photovoltaic power generator according to the present invention may be implemented in various embodiments as follows. The embodiments shown in the drawings and the following description are illustrative, and the scope of the present invention is not limited to the embodiments in the drawings and the following description. In the following embodiments and example, the case where an installation surface is a roof is mainly described as an example. The following description is also basically applied to the case where the installation surface is somewhere other than a roof (for example, an empty lot, a bank, a slope of a mountain, or the like).

### 1. Support System For Installing Photovoltaic Power Generator

The system according to the present invention may be structured using a computer. The system according to the present invention includes various types of means (an installation site input means, an installation surface shape specification means and the like) and various types of databases (a price database and the like). These components may be realized by a single computer or plural computers. These plural computers may be separated from one another or connected to one another through telecommunication lines (LANs, Internet and the like) for enabling data transmission and reception thereamong.

The system according to the present invention may be realized by installing, into a computer, a program which enables the computer to function as the aforementioned databases and means. Such a program is also included in the scope of the present invention. Such a program can be also provided in a state where it is recorded in a computer-readable recording medium or can be provided through a network.

### 2. Installation Surface Image Database

The installation surface image database stores an installation surface image including an installation surface on which photovoltaic modules (hereinbelow, also called "module") are to be installed and a gauge disposed on the installation surface and whose actual dimensions are known. The installation surface is a region of a finite area. The installation surface image is an assembly of pixels arranged on a grid stored in a format conformed to, for example, BMP, JPEG, TIFF, or the like. The image is managed in a file or folder for each of installation sites of the photovoltaic power generator. For example, in the case of file management, the image may include information such as the ID number of a customer, and in the case of folder management, the image may be included in a folder distinguishable by the name. An installation surface image file and a customer information file storing the address of an installation site, the upper limit of the installation cost, electricity fee, a house maker, a model name, and the like may be stored in the same folder.

With the database, for example, distribution of installation surfaces already estimated by a salesperson can be known. By recognizing the distribution, areas where photovoltaic power generators are actively introduced, undeveloped areas and the like can be known. The information can be used for sales activities, urban planning, and the like.

Although an installation surface image may be captured from the ground, preferably, it is captured from above the installation surface. In the case of installing a photovoltaic power generator on the roof of the second floor of a customer in a residential area where houses are densely built or the like, there is a case such that a predetermined photographic distance cannot be assured and it is difficult to capture an image. In such a case, photographing is performed above the roof surface by using a photographic device attached to the tip of a rod or the like. By the photographing, the installation surface shape can be specified. Thus, more accurate estimation can be given. It is also possible to obtain an installation surface image including a gauge from an image or the like taken from the above by a photographic device or the like attached to a radio-controlled flying matter or the like.

The photographic device for an installation surface image includes a dedicated digital camera for photographing an installation surface from the above, a portable information terminal device for performing zoom-in/zoom-out of the dedicated digital camera and shutter operation in hand of the user, a pole for the dedicated digital camera, for fixing the dedicated digital camera at a height at which the installation surface can be photographed, a communication cable for connecting the dedicated digital camera fixed at the tip of the pole for the dedicated digital camera and the portable information terminal device in hand, a disc-shaped gauge mounted on the roof surface so as to be used as reference of dimensions, a pole dedicated to the gauge, having a rod structure for mounting the gauge onto the roof surface, and a detachable memory unit for temporarily storing image data of the installation surface received by the portable information terminal device from the dedicated digital camera. In each of the dedicated digital camera and the portable information terminal device, dedicated software newly developed for performing photographing by a remote operation is assembled.

All of the functions (such as the zoom-in/zoom-out/shutter functions) of the dedicated software can be executed by an operation from the portable information terminal device. Image data of the roof surface captured is stored in the memory unit which is inserted in advance in the portable information terminal device. The memory unit is detached from the portable information terminal device and the data in the memory unit is stored as the installation surface image data in a computer capable of executing the system.

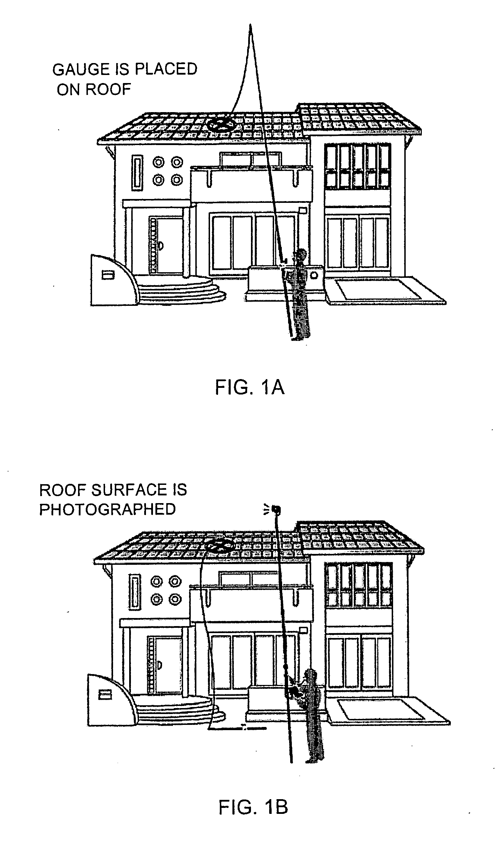

Capture of an installation surface image in the case where the installation surface is the roof surface of a house as an example will be described more specifically.
As shown in Fig. 1A, a fishing line is attached to the pole dedicated to the gauge like a fishing rod, the disc-shaped gauge as a reference of dimension measurement is attached at the tip of the fishing line, and the pole dedicated to the gauge is extended at maximum. The user moves with the pole dedicated to the gauge to put the gauge on the roof surface on which photovoltaic cells are to be mounted so as not to damage roof tiles and the like. The user operates the reel to loosen the line, contracts the pole dedicated to the gauge, and puts the pole in a place so as not to disturb a ground work.

As shown in Fig. 1B, the digital camera is attached to the tip of the pole for the dedicated digital camera separately prepared. The dedicated communication cable is connected to the digital camera and to the portable information terminal which is in hands of the operator on the ground. The pole for the dedicated digital camera is extended at the maximum. Since the length of the pole for the dedicated digital camera is about 6 meters, the communication cable is fixed in at least two portions of the tip portion and the hand portion in the pole for the dedicated digital camera.

When the power of the portable information terminal in hand is turned on to start roof picture capturing software preliminarily loaded in the portable information terminal, the dedicated digital camera responds it and the power is on. At this time, an image being captured by the dedicated digital camera is displayed on the screen of the portable information terminal.

The pole for the dedicated digital camera is raised and directed toward the roof surface on which the gauge was placed. It is confirmed that the whole roof surface on which the gauge is placed lies in the screen by performing zoom-in/zoom-out or the like by movement of the pole for the dedicated digital camera and an operation on the portable information terminal. After that, the shutter is released by an operation on the portable information terminal. Image data of the roof surface is transmitted from the dedicated digital camera via the communication cable and recorded in the memory unit inserted in the portable information terminal. A proper file name is given to the captured image data of the roof picture, and the image data is stored in a personal computer in which the system is assembled and which can be connected to the Internet.
As another example, a digital camera is mounted on a radio-controlled flying matter and the roof surface is photographed by an operation on a controller in hand.

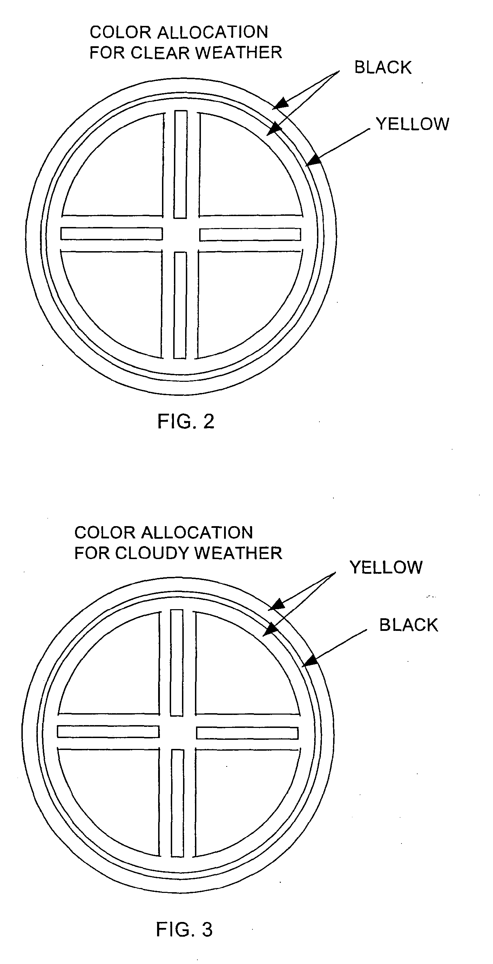

For the gauge as a reference of dimensions, basically, two colors are employed. It is found out by experiments that, when a yellow ring on a black base is used at the time of clear weather as shown in Fig. 2 and a black ring on a yellow base is used at the time of cloudy weather as shown in Fig. 3, the ring portion as the reference of dimensions is recognized more easily.

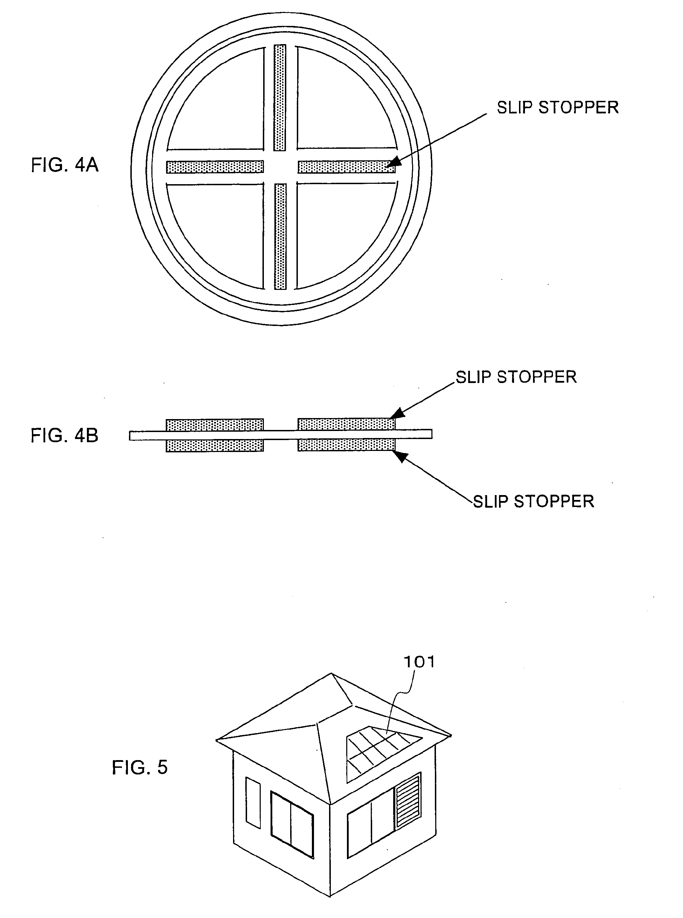

Although it is preferable to employ a light material for the gauge so as not to damage a roof material or the like which is the installation surface, for example, slip stoppers made of urethane may be adhered to both sides of the gauge so that the gauge placed on a tilted roof is prevented from being slipped down as shown in Figs. 4A and 4B. The slip stoppers also play the role of a protector for protecting the roof surface from damage.
Preferably, the gauge has a plate shape. More preferably, the gauge has a circular shape.

### 3. Installation Site Input Means

The installation site input means receives inputs about installation sites of photovoltaic modules. The "installation site" refers to a site where an installation surface exists, wherein the prefecture name and the city name, as well as the address including the block number, are also included therein. As a method for inputting thereto, there are a method for inputting the address in a text box provided on a screen, a method for selecting an area from plural candidate areas and a method for clicking, using a mouse or the like, on links having area names written thereon. It is also possible to utilize a method for accessing the installation site input means from a portable terminal equipped with a position detection means such as the GPS and inputting a current position of the portable terminal. In this case, the current position is designated by the longitude and the latitude, thereby enabling specifying the installation site with higher accuracy than the case of using the address or the like.

### 4. Installation Surface Image Display Means

The installation surface image display means reads a captured installation surface image from the installation surface image database and displays it on the display means (such as a display). For example, in the case where an address is entered as an installation site, the customer ID of the corresponding address is retrieved and the corresponding installation surface image can be displayed. Alternatively, an image file may be temporarily stored in advance in a dedicated directory.

### 5. Installation Surface Input Means

The installation surface input means receives inputs for specifying installation surfaces on a displayed installation surface image. For example, by inputting plural points forming the vertexes of a polygon, the polygon can be created and an installation surface can be specified from the polygon. The inputting of the vertexes of a polygon can be performed by clicking on plural points of an installation surface image or inputting coordinates in text boxes. The shapes of installation surfaces are not limited and may be round shapes, semi-round shapes or the like. The inputting for specifying installation surfaces may be performed with various methods which enable specification of the installation surface. The number of installation surfaces to be specified therein may be one or more. For example, when a roof is constituted by four surfaces oriented in different directions (see Fig. 5), it is possible to specify the respective surfaces and obtain information as to which surface should be used for installing a photovoltaic power generator thereon for providing a largest efficiency. Also, in the case of houses with several roofs, it is possible to specify the several roofs, for example, in order to estimate the power generation amount and the installation cost of when photovoltaic power generators are installed on all the roofs.
Further, the term "installation surfaces" includes grounds (vacant grounds, banks and hillsides and the like), as well as the roofs of buildings.

### 6. Installation Surface Shape Specifying Means

The installation surface shape specifying means specifies the shape of an installation surface (hereinbelow, also called "installation surface shape") on the basis of dimensions of the gauge in an installation surface image (hereinbelow, dimensions in an installation surface image will be called "appearance dimensions").

The installation surface shape specifying means specifies an installation surface shape on the basis of, for example, the ratio between actual dimensions of the gauge and appearance dimensions of the gauge.
It is considered that the ratio between the actual dimensions of the gauge and the appearance dimensions of the gauge is the same as the ratio between the actual dimensions of an installation surface and appearance dimensions of the installation surface. Therefore, the relation of "actual dimensions of the gauge" : "appearance dimensions of the gauge" = "actual dimensions of the installation surface" : "appearance dimensions of the installation surface" is satisfied. From the relation, the relation of "actuation dimensions of the installation surface" = (appearance dimensions of the installation surface)x{(actual dimensions of the gauge) / (appearance dimensions of the gauge)} is obtained.
The actual dimensions of the gauge are known. The appearance dimensions of the installation surface and those of the gauge can be obtained from an installation surface image displayed on the display means. By substituting the dimensions for the equations, the actual dimensions of the installation surface can be obtained. By obtaining the dimensions of the sides of the installation surface by such a method, the installation surface shape can be specified.

In place of using the ratio between the actual dimensions of the gauge and the appearance dimensions of the gauge, a table in which the appearance dimensions of the gauge and correction factors are associated with each other is prepared. By multiplying the appearance dimensions of the installation surface with the correction factor obtained by using the table, actual dimensions of the installation surface may be obtained.
An installation surface shape may be specified by, for example, the method disclosed in Japanese Unexamined Patent Application Publication No. 2004-45203.

Further, an installation surface shape may be specified as follows. A rectangular region is designated in an installation surface in an installation surface image displayed on the display means. Opposite sides of the rectangular shape are extended and an intersecting point of the sides is set as a vanishing point. Vanishing lines are drawn from the vanishing point towards both sides of the gauge and the center. An intersection point between each of the vanishing lines and a side of the rectangle is obtained. On the basis of a compound ratio from the length in the image between the intersection points and actual dimensions between both sides of the gauge and the center, the dimensions of the vertical and horizontal sides of the rectangle are calculated. From the calculated dimensions, the shape of the installation surface may be specified. In this case, the gauge has preferably a circular shape so that the actual dimensions between both sides of the gauge and the center are always constant.

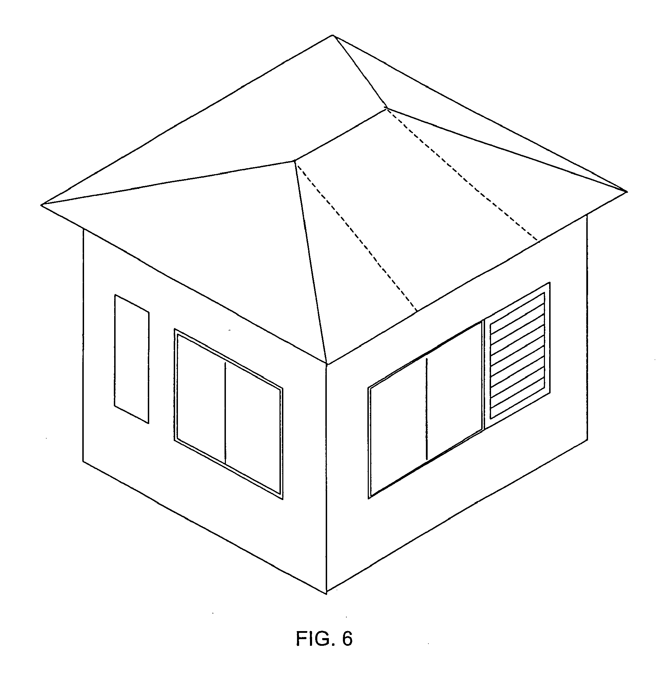

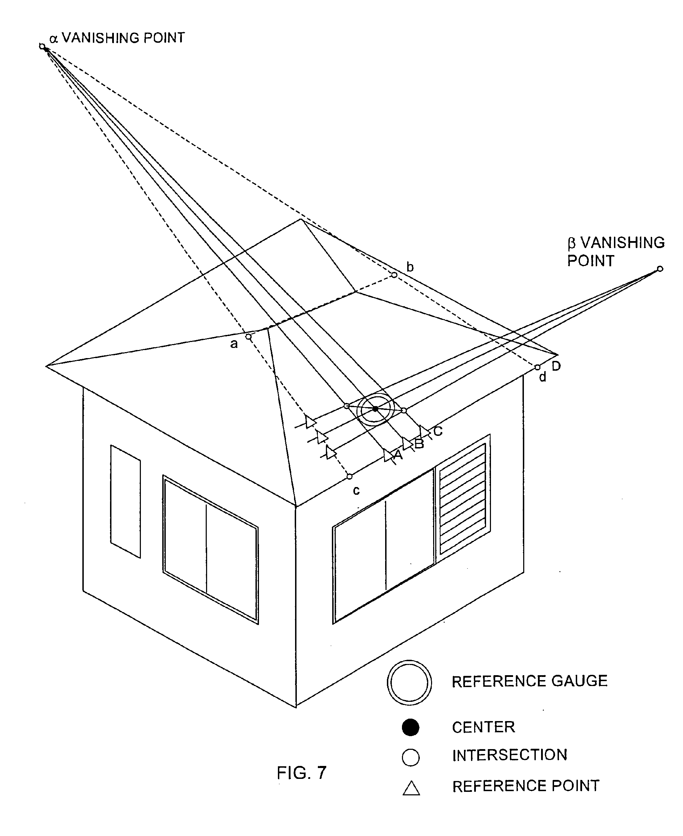

The rectangular region setting method is not limited. In the case where the installation surface has a rectangular shape, the whole installation surface may be set as a rectangular region. A rectangular region may be set in a range narrower or wider than the installation surface. When the installation surface is not rectangular, for example, as shown in Fig. 6, perpendicular lines (shown by broken lines) are drawn straight from the right and left corners of the ridge (the top of the roof), and a region surrounded by the perpendicular lines, the ridge and the edge of the eaves may be set as a rectangular region. As shown in Fig. 7, it is also possible to draw perpendicular lines from points a and b at arbitrary positions on extension lines of the ridge toward the edge of the eaves, set cross points between the perpendicular lines and the edge of the eaves as point c and d, and set a region surrounded by the points a, b, c, and d as a rectangular region.

Fig. 7 shows a figure drawing method in the case of specifying an installation surface shape by the method using the compound ratio. According to the method, the actual dimensions of a line segment ac and a line segment cd are obtained with relatively high precision. The actual dimension of the line segment ac corresponds to the distance between the ridge and the edge of the eaves. When the actual dimension of the line segment cd is obtained, the actual dimension of the ridge or the edge of the eaves can be easily obtained from the ratio between the appearance dimension of the line segment cd and the appearance dimension of the ridge or the edge of the eaves. Therefore, all of dimensions necessary for specifying the installation surface shape can be obtained.

When the system further has an installation surface tilt input means for receiving an input of the tilt of the installation surface, the installation surface shape specifying means can specify the installation surface shape from the installation surface image database specifying an input tilt and perpendicular lines. In the case where the system further includes an installation surface tilt database indicative of the relation between the manufacturer or model name of the installation surface and the tilt of the installation surface and an installation surface information input means for receiving the manufacturer or model name of the installation surface in order to determine specifications of the installation surface, the installation surface shape specifying means reads the specification as a tilt of the installation surface corresponding to the input manufacturer or model name from the installation surface tilt database. The installation surface shape can be specified from the read tilt of the installation surface and the installation surface image designating perpendicular lines. In some cases, the customer does not know the concrete shape of the roof but knows the manufacturer of the roof. In this case, the installation surface shape can be easily specified.
By obtaining the installation surface shape as described above, the length of the ridge line of the installation surface is obtained accurately, and the shape of the installation surface can be obtained accurately.

Preferably, the specified shapes of the installation surfaces are stored in the installation surface shape database. The shapes of installation surfaces stored in this database can be used by a module determination means or an estimation means, for example, when these means does over module determination or estimation.

### 7. Module Determination Means

The module determination means determines the type and the layout of the modules suitable for the shape of the installation surface specified by the installation surface shape specification means. The module determination means may directly receive the output from the installation surface shape specification means or may further include an installation surface shape input means for receiving inputs about the shape of the installation surface. The module determination means determines the type and the layout of the modules suitable for the shape of the installation surface. For example, a computer, an operator, a user or a customer inputs the output of the installation surface shape specification means to the installation surface shape input means.

As the method for determining the type and the layout of the modules, for example, there are two possible embodiments.
In the first embodiment, the system according to the present invention further includes a module information database storing shapes of the modules, and the module determination means calculates a maximum area capable of mounting the modules thereon from the shape of the installation surface and determines the type of the modules and the layout of the modules from the aforementioned area and the shapes of modules read from the aforementioned database. The module information database stores various module types with different shapes (trapezoidal shapes, rectangular shapes, square shapes and the like) or different sizes. The module determination means selects suitable modules from the database and places them on the aforementioned calculated maximum area. The selection and the placement of modules may be performed by various methods and, for example, may be performed such that the area on which modules are not placed becomes smallest. Further, the calculation of "the maximum area" may be performed by detecting the edge of the installation surface shape and setting the area within a predetermined distance (for example, 30 cm) from the edge to an uninstallable area. Once the type and the layout of the modules are determined, it is possible to determine mounting structures required for installation, necessary parts such as cables, and a power conditioner constituted by an electric power conversion device and the like.

In the second embodiment, the system according to the present invention further includes a placement pattern database storing plural placement patterns of the modules, and the module determination means makes a comparison between the respective placement patterns in the placement pattern database and the aforementioned specified installation surface shape and selects a placement pattern suitable for the installation surface shape to determine the layout. The placement pattern database stores various types of placement patterns in association with installation area contours (shapes and sizes) and the like. In this case, the module determination means determines the contour of the installation surface shape, makes comparisons between the determined contour and the respective installation area contours in the database and selects a candidate having an installation area closest thereto. Further, similarly to the embodiment above, it is possible to determine mounting structures required for installation, necessary parts such as cables, and a power conditioner constituted by an electric power conversion device and the like.

The module determination means may further include means for suggesting plural candidates for the selection and the placement of modules and a module selection means for receiving an input for a candidate selected from the suggested candidates. In this case, a computer, an operator, a user, a customer or the like can select modules arbitrarily from plural candidates and may cause a computer to perform the calculation of estimation.
Moreover, the system according to the present invention may include a module input means for receiving inputs about the type and the layout of the modules suitable for the shape of the installation surface shape, instead of the module determination means. In this case, instead of determining the type and layout of the modules by a computer, for example, a computer, an operator, a user, a customer or the like can select, from a list, a type and a layout of the modules adaptable to the installation surface shape and causes a computer to perform the calculation of estimation.

Preferably, the module determination means may optimize the type and layout of the modules such that the value of the prospective power generation amount divided by the estimated price gets higher. The optimization can be performed by increasing or decreasing the number of the modules one by one, calculating the aforementioned divided value for each of the cases and then making comparisons among the respective divided values.

The roof shapes are not limited to normal shapes such as rectangle, trapezoid, parallelogram, and the like but include various roof shapes such as rounded normal shapes and a shape including a roof light window.
Even in the case of a roof with normal shape, there is a case that portion of photovoltaic modules cannot be mounted because of, for example, a projection such as a snow stop.
To deal with such an installation surface, preferably, a layout can be determined by increasing/decreasing the number of modules one by one. For example, it is preferable to retrieve a model of a base which can be attached in a layout that photovoltaic modules corresponding to the portion of the roof light window are removed.

By storing a base model which is designed in advance on the outside into a module/base database, the maximum layout in which the maximum number of photovoltaic modules can be installed within the installation surface dimensions calculated from the installation surface image is retrieved and can be easily displayed on the screen. In this case, it is not necessary to calculate the maximum layout pattern each time and select an attachment member adapted to the maximum layout pattern. Therefore, computer processing time is reduce, and thus this method is suitable for the case where a number of users simultaneously use the system on the Internet. Since the database is associated with an attachment base ordering system and a design element and individual judgment are not included, installation of the photovoltaic power generation system can be completed in short time with uniform quality.

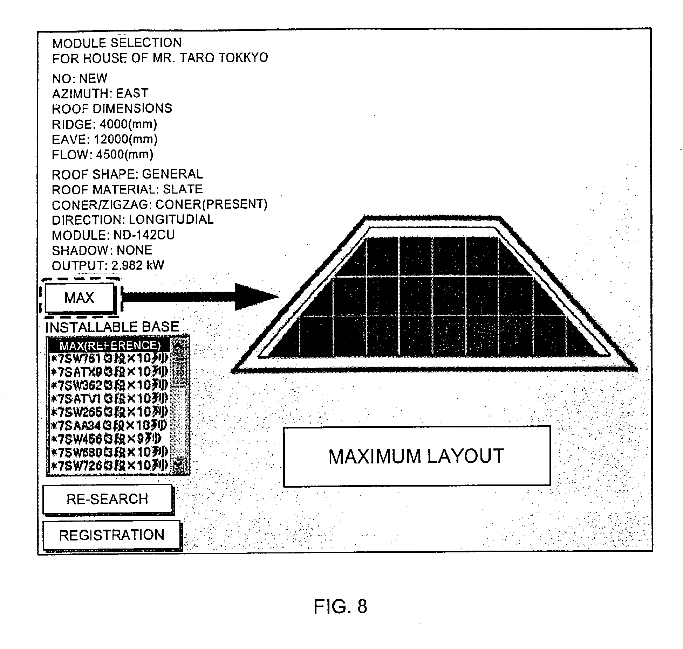

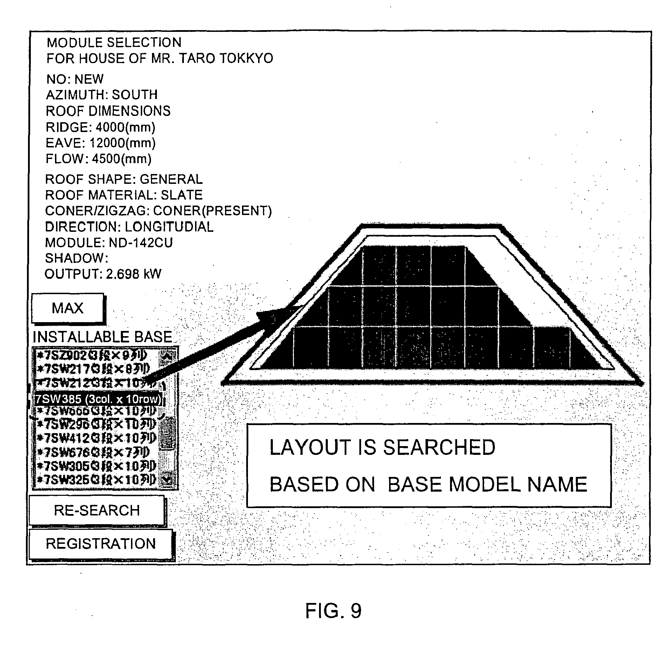

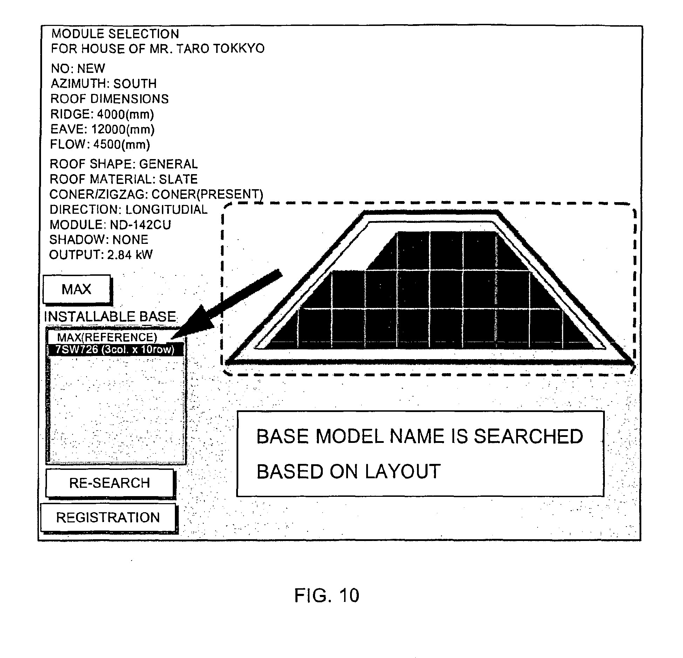

It is possible to select the layout of the photovoltaic modules by selecting the model name of an installable base as shown in Fig. 9 in accordance with the installable maximum layout of the photovoltaic modules retrieved as shown in Fig. 8. Therefore, it is preferable that the module determination means can retrieve the model of a base to which the photovoltaic modules can be attached.
Furthermore, as shown Fig. 10, it is possible to select photovoltaic modules included in the maximum layout displayed on the roof drawing of the computer screen, and delete the photovoltaic module or replace it with a module of another shape. Moreover, it is possible to retrieve a model name with corresponding specifications from the database of the attachment base registered in the server by operating a specific button. It is therefore preferable that the module determination means can delete or change an arbitrary photovoltaic module on the basis of a layout which can be mounted in the maximum installation area.

### 8. Estimation Means

The estimation means calculates the estimated price of the installation of a photovoltaic power generator on the basis of the type and layout of the modules determined by the module determination means. The estimation means, for example, reads the prices of the modules used in the aforementioned layout, from a price database storing the prices of the modules, and calculates the estimated price of the installation of a photovoltaic power generator. The estimation means may either calculate the estimated price after the determination of the layout or calculate the estimated price in parallel with the placement of the modules for the determination of the layout (for example, the first embodiment of the module determination means). In the latter case, for example, each time a single module is placed, the price of the module is added to the total price to calculate the estimated price.

Further, in the case where the system according to the present invention further includes an upper limit price input means for receiving an input about the upper limit of the installation price, the estimation means may make a comparison between the aforementioned upper limit price and the estimated price from the estimation means, and the module determination means may change the type and the layout of the modules, on the basis of the result of comparison. The changing of the type and layout of the modules is, for example, changing the modules to more inexpensive ones, reducing the number of the modules and the like. This enables performing estimation such that the aforementioned upper limit price is not exceeded.

The estimation means may add, to the estimated price, such as the installation cost and the transport cost as well as the prices of the modules. For example, in cases where the modules are installed at a site distant from an air port or a port, the estimation means can add, to the estimated price, the cost for transporting them from the air port or port to the installation surface. For calculating transport costs, the system according to the present invention may further include a distance calculation means for calculating the distance from an airport or a port to the installation surface and a transport cost database storing transfer costs for respective areas and respective transporting methods. The position of an airport or port may be input to a starting position input means which receives an input about such a position. Further, the transporting method may be properly selected on condition that priority is given to the time, the cost, or the like.

Further, it is preferable that the aforementioned price database, the transport cost database, and the like are structured such that their contents can be changed depending on various situations.

### 9. Power Generation Amount Prediction Means

The system according to the present invention may further include a power generation amount prediction means for calculating the prospective power generation amount. In order to realize this, the system according to the present invention may further include a module information database storing specifications about power generation performance (the rated electric power and the like) of the modules and a solar amount information database storing measurement points covering various places and monthly-mean day-accumulated slope solar-radiation-amount data in a slope in each of the points. The power generation amount prediction means may be configured to calculate the prospective power generation amount, from the specifications, the measurement points covering various places, the monthly-mean day-accumulated slope solar-radiation-amount data in a slope at each of the points, and the installation surface shape. Since the installation surface shape includes information about the orientation of the installation surface, it is possible to simply calculate the prospective power generation amount, by knowing the measurement positions covering various places and the monthly-mean day-accumulated slope solar-radiation-amount in the slope at each of the positions.

The system according to the present invention may further include a desired power generation amount input means for receiving an input about a desired power generation amount, the power generation amount prediction means may make a comparison between the desired power generation amount and the prospective power generation amount, and the module determination means may change the type and layout of the modules on the basis of the result of comparison. For example, when the prospective power generation amount is significantly greater than the desired power generation amount, the number of the modules can be reduced, while when the prospective power generation amount does not reach the desired power generation amount, the number of the modules can be increased, in order to determine the type and layout of the modules appropriate to the desired power generation amount.

### 10. Payback Time Optimization Means

The system according to the present invention preferably further includes an optimization means for optimizing the type and the layout of the modules such that the payback time is decreased. Therefore, the system according to the present invention may be configured to include an electricity price database storing the purchase price of electricity (for example, the purchase price of a unit amount of electricity) or an electricity price input means for receiving an input about the purchase price of electricity, an electricity usage input means for receiving an input about the electricity usage, a payback time calculation means for calculating the reduction of the electricity charge due to the installation of a photovoltaic power generator, from the difference between the prospective power generation amount and the electricity usage and the purchase price of electricity, making a comparison between the reduction and the estimated price (or dividing the estimated price by the reduction) to calculate the payback time of the photovoltaic power generator, and a payback time optimization means for repeating a process of changing the type and layout of the modules and calculating the payback time to optimize the type and layout of the modules such that the payback time is reduced. The "inputting of the electricity usage" may be performed by inputting the amount of electricity or the electricity charge (the amount of electricity and the electricity charge can be inter-converted through the purchase price of electricity). The aforementioned structure enables calculating the time period required for recovering the installation cost for the system according to the present invention by saving the electricity charge with the installed system according to the present invention and also enables optimizing the type and the layout of the modules such that the aforementioned time period is reduced. The optimization can be performed by reducing the number of the modules one by one, calculating the payback times for the respective cases and making comparisons among the payback times of the respective cases.

The aforementioned structure is made in consideration of only the purchased electricity and is not made in consideration of profits derived from selling surplus electricity to electric power utility companies. By taking account of such profits, it is possible to optimize the type and the layout of the modules with higher accuracy. In order to attain this, the electricity price database may further store the selling price of electricity or the electricity price input means may further receive an input about the purchase price of electricity, the payback time calculation means may calculate the reduction of the electricity charge due to the installation of a photovoltaic power generator, from the difference between the prospective power generation amount and the electricity usage and the selling price and the purchase price of electricity, make a comparison between the reduction and the estimated price to calculate the payback time of the photovoltaic power generator.
The aforementioned database storing the selling price and the purchase price of electricity may be incorporated in the computer of the system itself. Also, it is possible to employ a database presented by an electric power utility company or the like, as such a database. Also, it is preferable to specify the electric power utility company which contracts with the customer from the address or the like of the installation site input from the installation site input means and access an electricity purchase/selling price database presented by this electric power utility company.

### 11. Image Synthesis Means

The system according to the present invention may further include an image synthesis means for superimposing the aforementioned layout on a proper position in the installation surface image or on the installation surface shape to create a synthesized image. This enables recognizing the installation pattern within the installation surface shape, thereby enabling clarifying the image after installation.

### 12. Installation Support Information Database

The system according to the present invention may further include an installation support information database storing installation support information consisting of at least one of an installation price, a prospective power generation amount and a synthesized image and may further include a data transmission means for transmitting installation support information stored in the installation support information database to customers and a browse means which enables browsing of the data.

The aforementioned method enables easily offering, to customers and the like, the results obtained by the system according to the present invention. Customers may be allowed to access customer data within the installation support information database on a customer-by-customer basis or may be allowed to access only a part of the content thereof. Also, the data transmission means may notify a method for accessing the installation support information database, instead of transmitting installation support information.

When customers are allowed to access the database, it is preferable to perform customer authentication. In order to perform this, the system according to the present invention may be configured to further include a customer identification database storing customer IDs and passwords, a password input means for receiving inputs of passwords corresponding to customer IDs and a customer authentication means for performing customer authentication by making a comparison between input passwords and data in the customer identification database. The customer identification database may further store information which has been previously input by customers (addresses, installation cost upper limits, required electric powers and the like), information about past estimations and transactions and the like. The various types of means which have been previously described may be enabled to access this database and, for example, the module determination means may determine the suitable type and layout of the modules by referring to the past information about customers.

### 13. Others

The contents of past estimations (prices, layouts, regions and whether or not the contract was made) and the like may be stored in a database so that they can be used for various statistical processes. The results of such statistical processes may be taken into account in, for example, determining estimated prices.

### (First Example)

There will be described an example of a support system for installing a photovoltaic power generator according to the present invention. The present example is mainly on the assumption that a photovoltaic power generator 101 is installed on the roof of a house as illustrated in Fig. 5. The photovoltaic power generator 101 is constituted by plural photovoltaic modules which are connected in series to one another, for example, and the direct current electric power extracted from the device is converted into an alternating-current electric power by a power conditioner device equipped with an inverter circuit. The alternating-current electric power is intended for home use. The shortfall of electricity is covered by electricity purchased from an electric power utility company through a utility power supply while the surplus of electricity is sold to the electric power utility company.

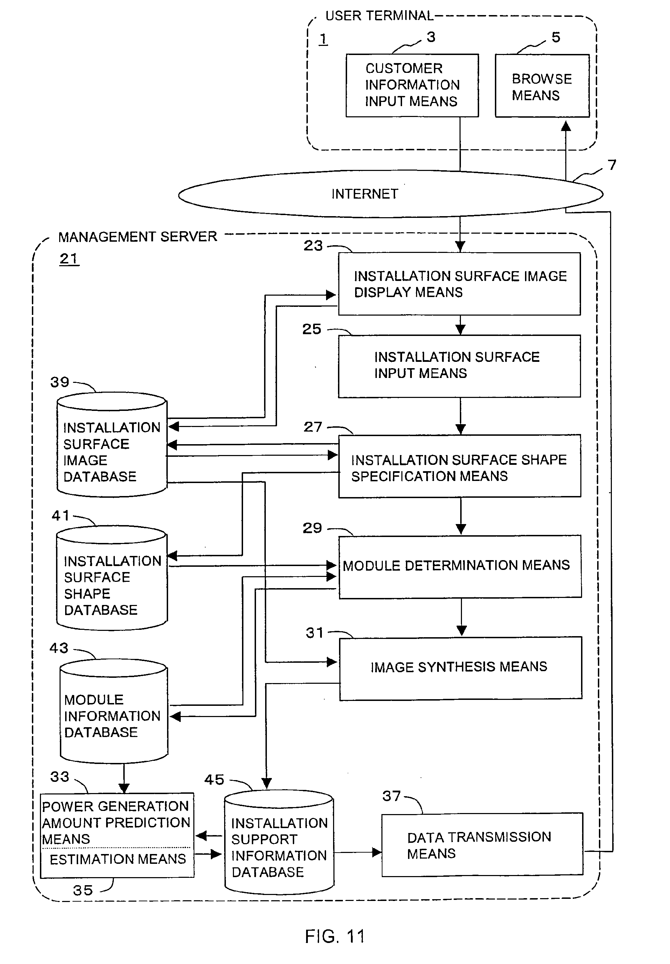

Fig. 11 is a configuration diagram of the installation support system according to the present example, wherein arrows indicate data flows. In the system according to the present example, a user terminal 1 and a management server 21 are interconnected through the Internet 7. The user terminal 1 includes a customer information input means 3 and a browse means 5. The management server 21 includes an installation surface image display means 23, an installation surface input means 25, an installation surface shape specification means 27, a module determination means 29, an image synthesis means 31, a power generation amount prediction means 33, an estimation means 35, a data transmission means 37, an installation surface image database 39, an installation surface shape database 41, a module information database 43 and an installation support information database 45.
Hereinafter, there will be described the flow until a customer receives estimation using this system.

### 1. Inputting of customer information

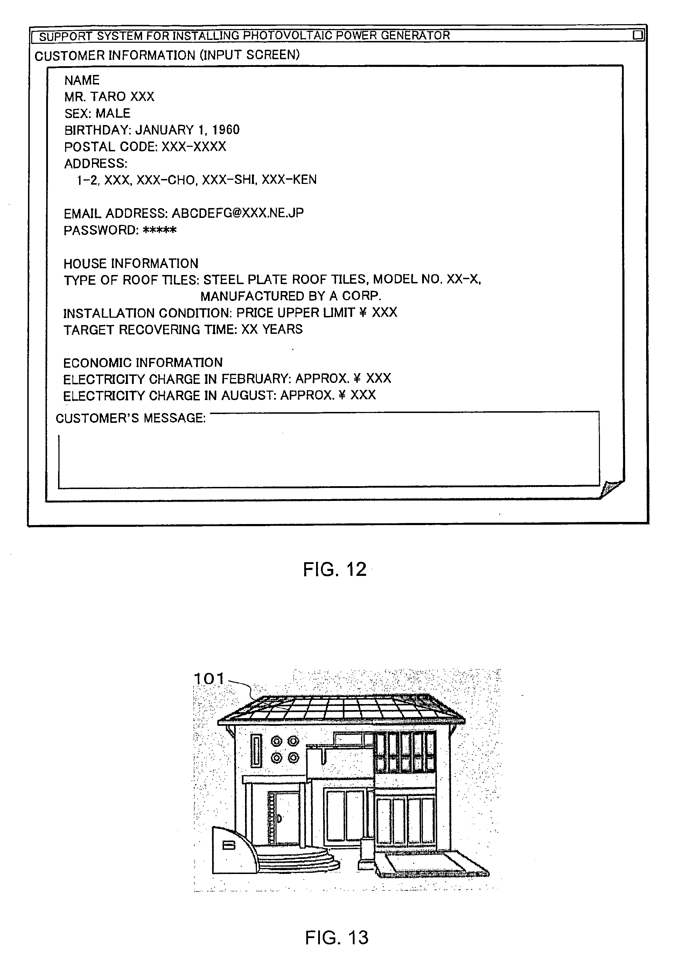

A customer who requests estimation of a photovoltaic power generator accesses a home page of the support system for installing a photovoltaic power generator according to the present invention and inputs customer information thereto in accordance with a customer information inputting screen as illustrated in Fig. 12, for example, by using the customer information input means 3 such as a keyboard of the user terminal 1 constituted by, for example, a stationary-type personal computer. For example, he or she inputs the customer's name, gender, birth date, postal code, address, email address, password, house information such as the type of roof tiles, the upper limit of installation cost, a target time for recovering the installation/maintenance cost (in other words, a target payback time), and economic information such as a monthly electricity charge in, for example, February during which a greatest amount of electric power is consumed by heaters and a monthly electricity charge in, for example, August during which a greatest amount of electric power is consumed by air conditioners. By using the input email address, it is possible to send, to a stationary terminal or a portable terminal, an access code for accessing the installation support information.

Further, there is provided a memo field which enables inputting questions and the like. As other inputting entries, there may be provided inputting entries for house makers or model names for enabling fine adjustment and correction of image data, since roof tilt data may be determined from the house maker or the model name. Once the customer completes required inputs, he or she clicks an inputting button to transmit the data to the management server 21 through the Internet 7.
Further, the customer information input means 3 includes "the installation site input means", "the password input means", "the upper limit price input means", "the electricity usage input means", and "the installation surface information input means" which have been described in the aforementioned preferred embodiment and the respective means can receive inputs about information described in the right stage of Table. 1.

**Table 1**

| **Name in the aforementioned preferred embodiment** | **Information** |
|---|---|
| Installation site input means | Customer's address |
| Password input means | Password |
| Upper limit price input means | Upper limit of installation cost |
| Electricity usage input means | Electricity charge |
| Installation surface information input means | House maker or model name |

### 2. Specification of Customer's House Image

The installation surface image display means 23 in the management server 21 extracts customer information from the received data and reads an image of a roof surface of a house corresponding to the customer information from the installation surface image database 39. Next, the installation surface image display means 23 displays the read roof surface image of the house on a display (display means) connected to the management server 5. Further, details have been previously described in "2. Installation Surface Image Database" and "4. Installation Surface Image Display Means" in the aforementioned preferred embodiment.
Hereinbelow, the case where a house can be specified is assumed.

### 3. Specification of Roof of Customer's House

Next, a computer, an operator, a user, the customer or the like specifies the roof of the aforementioned house, by using the installation surface input means 25 which is, for example, a mouse. This specification may be performed by enclosing, with a polygon, the portion corresponding to the roof on an installation surface image displayed on the display (the specification of the polygon may be performed by clicking the respective vertexes thereof by the mouse or the like). Details have been previously described in the paragraph of "5. Installation Surface Input Means" in the aforementioned preferred embodiment.
Also, this specification may be performed by causing a computer to automatically extract peculiar points such as the edges of the roof or the joint portions of ridges through image processing.

### 4. Specification of Installation Surface Shape

Next, the installation surface shape specification means 27 calculates the shape and area from the installation surface image of the specified roof input by the installation surface input means or the installation surface image in which the installation surface is input, read from the installation surface image database 39 and the image of the gauge mounted on the installation surface. The specified installation surface shape and area are stored in the installation surface shape database 41. The details have been previously described in the paragraph of "6. Installation Surface Shape Specification Means" in the aforementioned preferred embodiment.

### 5. Determination of Type and Layout of the Modules

The aforementioned three-dimensional roof shape is transmitted to the module determination means 29. The module determination means 29 determines the type and layout of the modules appropriate to the installation conditions within the roof shape, by using module information data acquired from the module information database (storing information about shapes of the modules, rated outputs and prices and the like) 43 in the management server 21. At this time, the installation conditions are, for example, the upper limit of the installation cost required for the initial investment and the target time for restoring the installation/maintenance cost based on the generated-electricity-to-money conversion. Further, since some photovoltaic modules can not be installed depending on the type of roof material, it is preferable that the data input to the customer information input means is utilized for the determination. The details have been previously described in the paragraphs of "7. Module Determination Means" and "10. Payback Time Optimization Means" in the aforementioned preferred embodiment.

### 6. Image Synthesis

The data about the aforementioned determined layout is transmitted to the image synthesis means 31, and the image synthesis means 31 superimposes the aforementioned determined layout on the aforementioned installation surface image to create a synthesized image. Fig. 13 illustrates an exemplary synthesized image. Further, the details have been previously described in the paragraph of "11. Image Synthesis Means" in the aforementioned preferred embodiment.

### 7. Storage in Installation Support Information Database, Prediction of Power Generation Amount and Estimation of Installation Cost

The aforementioned type and layout of the modules and the aforementioned created synthesized image are stored in the installation support information database 45. The power generation amount prediction means 33 extracts module power generation data in the module information database 43 and the layout including latitude and longitude information and the like in the installation support information database 45 and predicts the annual power generation amount and the like. The estimation means 35 extracts module price data in the module information database 43 and the layout including roof material information and the like in the installation support information database 45 and calculates the estimated price such as the installation cost and the maintenance cost. Further, economic simulations may be executed by referring to the customer's electricity usage during the respective months. The various data created as aforementioned is stored as installation support information in the installation support information database 45 on the basis of customer by customer. Further, details have been previously described in the paragraphs of "8. Estimation Means", "9. Power Generation Amount Prediction Means" and "12. Installation Support Information Database" in the aforementioned preferred embodiment.

### 8. Data Transmission

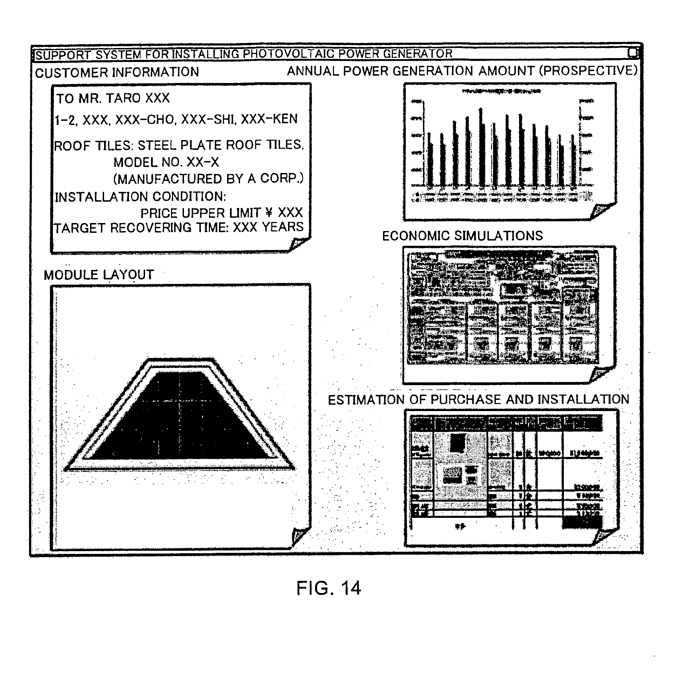

The installation support information is transmitted to the user terminal 1 through the data transmission means 37, and the browse means 5 in the user terminal 1 displays it. Fig. 14 is an installation support information output screen displayed by the browse means 5. In addition to the customer's information, there is displayed a module layout image which is a realistically synthesized geographic information image which has been subjected to rotation processing such that, for example, the upper part is oriented in the north direction. There are also displayed the annual power generation amount (prospective), economical simulations and the purchase/installation estimation and the like and, when the image is clicked, it is enlarged, thereby offering detailed explanation to the customer. Further, the browse means may be realized by printing information through a printer or mailing it from a system manager at a later date.

### (Second Example)

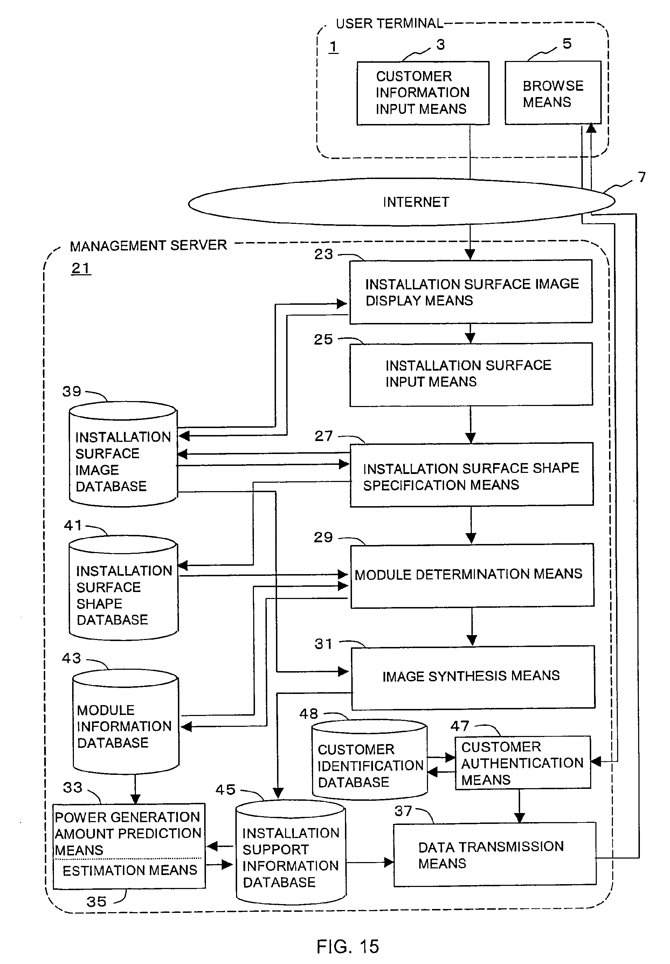

Fig. 15 is a block diagram of a support system for installing a photovoltaic power generator according to a second example, wherein arrows indicate data flows.
The present example is different from the first example in that the system additionally includes a customer authentication means 47 and a customer identification database 48.

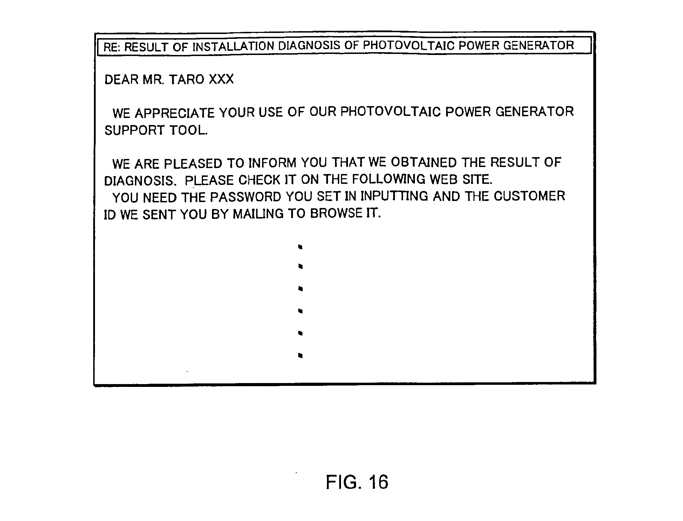

In the present example, the data transmission means 37 transmits an email indicating the completion of estimation and the like (with a statement as illustrated in Fig. 16, for example) to the user terminal 1. When the customer browses the installation support information with the browse means 5 of the user terminal 1, user authentication is performed. The customer information input means 3 in the present example includes customer ID/password input means. Input information is transmitted to the customer authentication means 47. The customer authentication means 47 accesses the customer identification database 48 in the management server 21 and makes a comparison between customer IDs and passwords in the database and the customer ID and the password input by the customer to perform customer authentication. When the customer authentication is succeeded, the customer authentication means 47 gives the data transmission means 37 permission to transmit the installation support information to the customer. On receiving the permission, the data transmission means 37 transmits the installation support information to the customer.

For example, the customer resisters his/her name, address and the like through Web and holds a customer ID code and a password while a system manager manages them. For example, the customer may resister a password thereto while the system manager may issue a customer ID code and send it to the house by postal mailing, in order to bidirectionally ensure the security for his/her personal information.

### (Third Example)

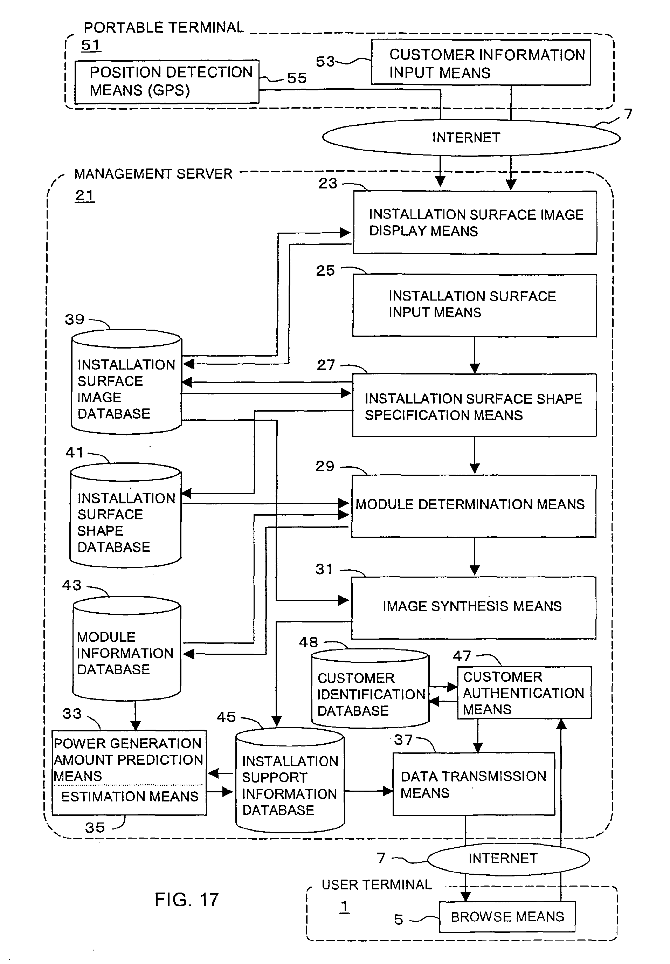

Fig. 17 is a block diagram of a support system for installing a photovoltaic power generator according to a third example, wherein arrows represent data flows.
The present example is different from the second example in that a customer information input means 53 included in a portable terminal 51 is employed for inputting customer information. Further, the portable terminal 51 includes a position detection means (GPS) 55. When the customer information is transmitted to the management server 21 through the Internet, the current position (the latitude and longitude) detected by the GPS 55 can be transmitted thereto. In this case, it is preferable that the current position is transmitted from the customer's house. For example, when the current position detected by GPS is separated from the input address by 5 meters or more, it is determined that the transmission from the portable terminal was performed outside the house and the input address is preferentially utilized. In the present example, the browse means 5 is incorporated in the user terminal 1. Therefore, an email indicating the completion of estimation and the like is transmitted from the data transmission means 37 to the user terminal 1 and, thereafter, customer authentication is performed with the same method as in the second example and the installation support information is transmitted to the customer.
While there has been described the example employing the portable terminal 51 and the user terminal 1, these functions may be integrated in a portable terminal equipped with a position detection means, a customer information input means and a browse means.

### (Fourth Example)

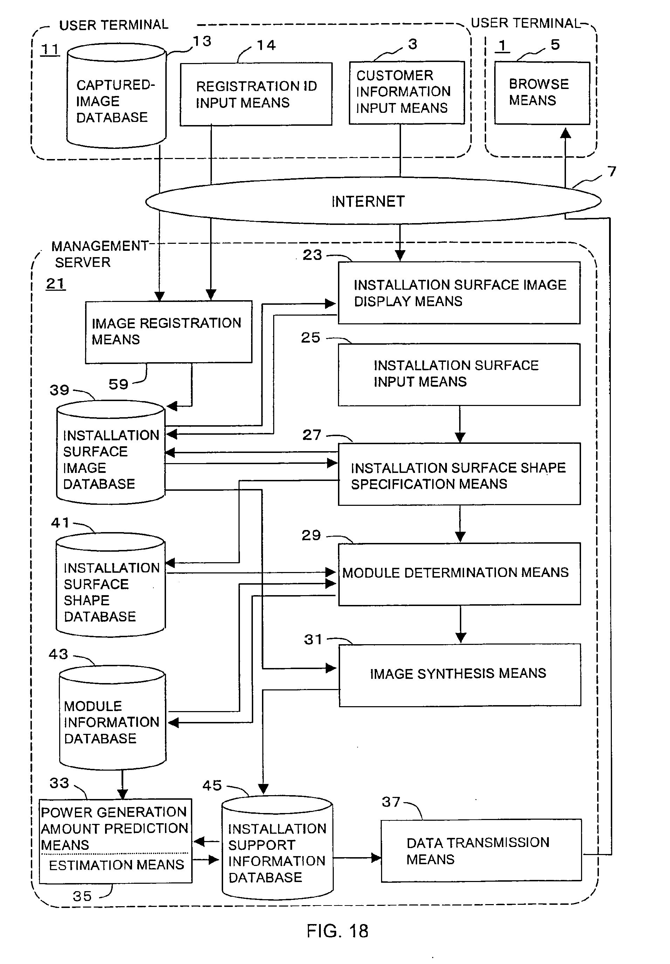

Fig. 18 is a block diagram of a support system for installing a photovoltaic power generator according to a fourth example, wherein arrows represent data flows. The present example is different from the first example in that the management server 21 includes an installation surface image registration means 59, and that a user terminal 11 for registering a captured image is added.

The user terminal 11 has a captured-image database 13 storing a customer's roof image and the like, a registration ID input means 14 to which, for example, a registration ID is input by an installation company, and the customer information input means 3.
Prior to use of the system, the user pre-stores an image of an installation surface on which a gauge is placed into a memory in the user terminal or the like. The flow is added with a step of inputting and registering customer information from the captured-image database to the management server after log in the management server with a registered ID.

### (Fifth Example)

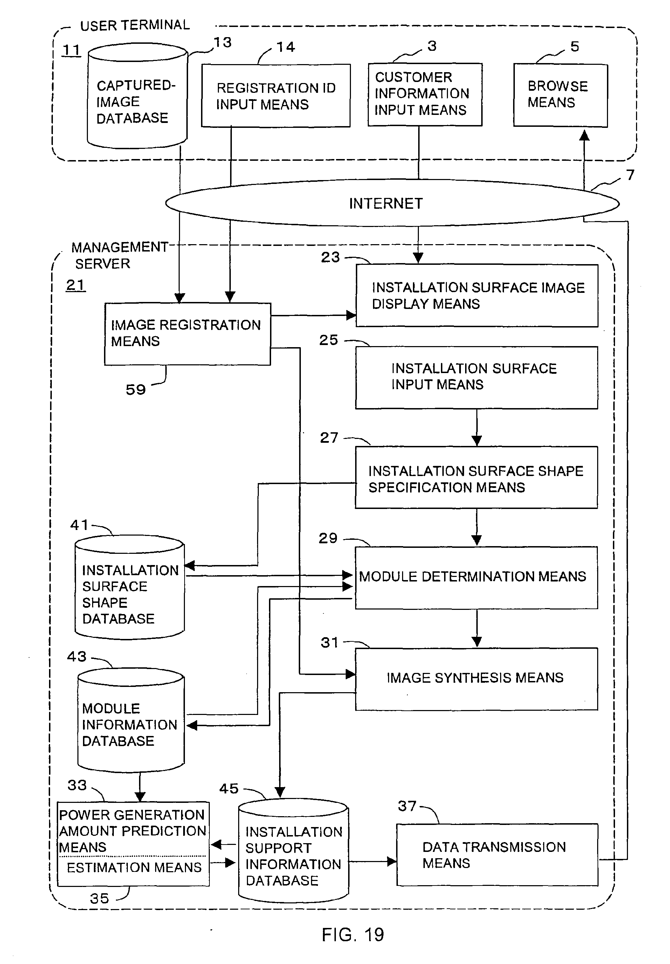

Fig. 19 is a block diagram of a support system for installing a photovoltaic power generator according to a fifth example, wherein arrows represent data flows. The present example is different from the fourth example in that the management server 21 does not have an installation surface image database, and data of an image transmitted and registered from the user terminal is directly used.

Security is enhanced with a password. In addition, in the example, an image is temporarily stored in the image registration means only for a period in which the installation support system performs simulation. When an access from the user terminal 11 is cancelled, installation surface image data does not remain in the management server. It further prevents the appearance of the roof of the customer from being seen by a third party by mistake.
Prior to use of the system, the user pre-stores an image of an installation surface on which a gauge is placed in a memory in the user terminal or the like. The flow is added with a step of inputting and registering customer information from the captured-image database to the management server after log in the management server with a registered ID.
In the case of the embodiment, a simulation result is browsed by the browse means while an access from the user terminal 11 continues.

### (Concrete Applications of First to Fifth Examples)

Hereinafter, there will be described concrete applications of the first to fifth examples.
The user terminal and the portable terminal in the first to fifth examples are operated by a customer, a salesperson or the like. An example of procedure for selecting a layout of photovoltaic modules will be described using a screen displayed on a terminal.

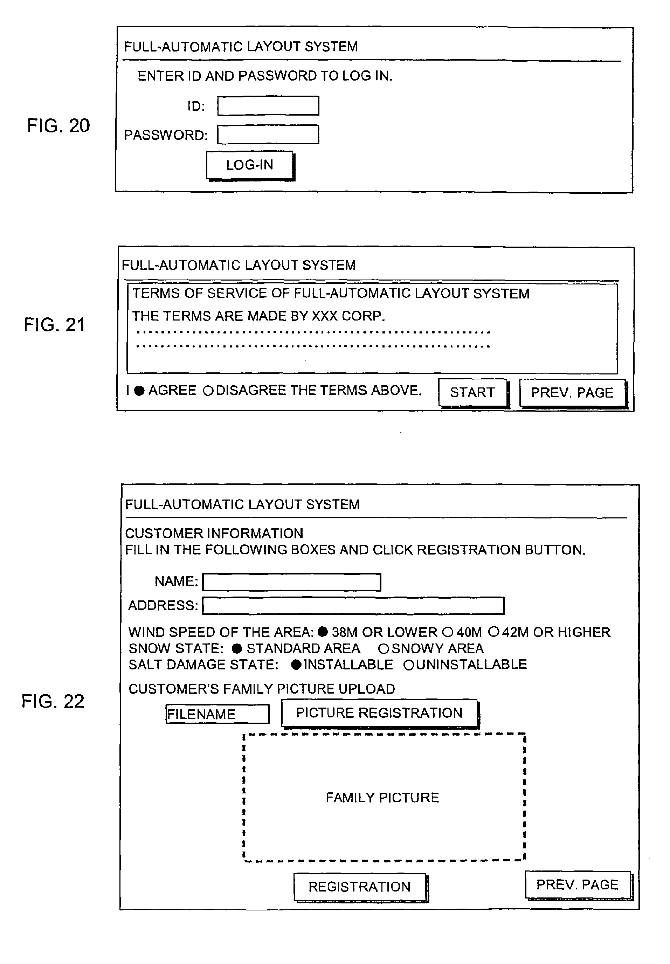

In the user terminal or portable terminal, a log-in screen as shown in Fig. 20 connected to the Internet and preliminarily assembled is displayed. Consequently, an ID number which is given in advance and a password obtained by a preceding operation are entered, and a log-in button is clicked.
On the screen of the terminal, terms of service on use of a full-automatic layout system as shown in Fig. 21 are displayed. A dealer reads the terms of service, when agreeable, checks "agree" on the screen, and clicks the start button. When unagreeable, the dealer checks "disagree", and click the start button, thereby going out from the full automatic layout site.

The following screen is a screen for entering customer information as shown in Fig. 22. The screen prompts the customer to enter his/her name which will be written in a proposal and an estimation automatically created at last and his/her address for obtaining an amount of solar radiation in an installation area necessary for calculating the power generation capacity of a photovoltaic power generation system.
By determining reference wind speed of the installation area, the presence or absence of accumulation of snow, the presence or absence of salt damage, and the like, whether a photovoltaic power generation system can be safely and effectively installed in the address or not is determined.

A solar cell attachment base registered in a server at present is designed with the reference wind speed of 30 m or less. In the case of installing the photovoltaic power generation system in an area where the reference wind speed is higher than 30 m, designing is additionally necessary.
In the case where the maximum depth of snow cover determined by a specific administrative agency in the area is 60 cm or more, it is necessary to use a solar cell attachment base of a snow specification with increased strength in correspondence with the pitch of roof.
In the case where the roof is directly exposed to sea splash, the photovoltaic power generation system cannot be installed at present..
Further, a customer's family picture registering function is added, of taking in a picture image which gives customers friendliness and reliability such as a picture of a customer's family or a picture of a dealer captured separately at the time of capturing an image of the roof surface as shown in Fig. 22. After the data entry, a registration button is clicked.

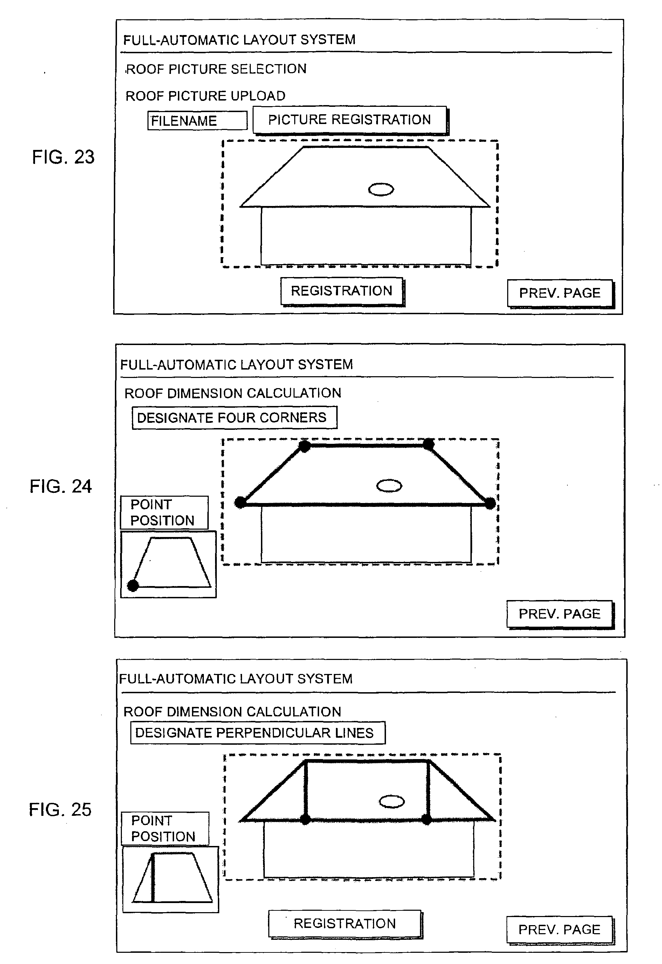

In Fig. 23, the roof picture captured in a state where the gauge is placed on the roof surface to actually install a solar cell is registered.
To calculate dimensions from the roof picture in which the gauge is placed, as shown in Fig. 24, points at the four corners of the roof are designated with the mouse in accordance with guidance of "point position" on the screen.
Subsequently, when the roof shape is not a square as shown in Fig. 25, perpendicular lines dropped straight from the right and left corners of the ridge (the top of the roof) are designated, and the registration button is clicked. Perpendicular lines can be accurately designated by using the points so as to be in parallel with the border lines of roof tiles.

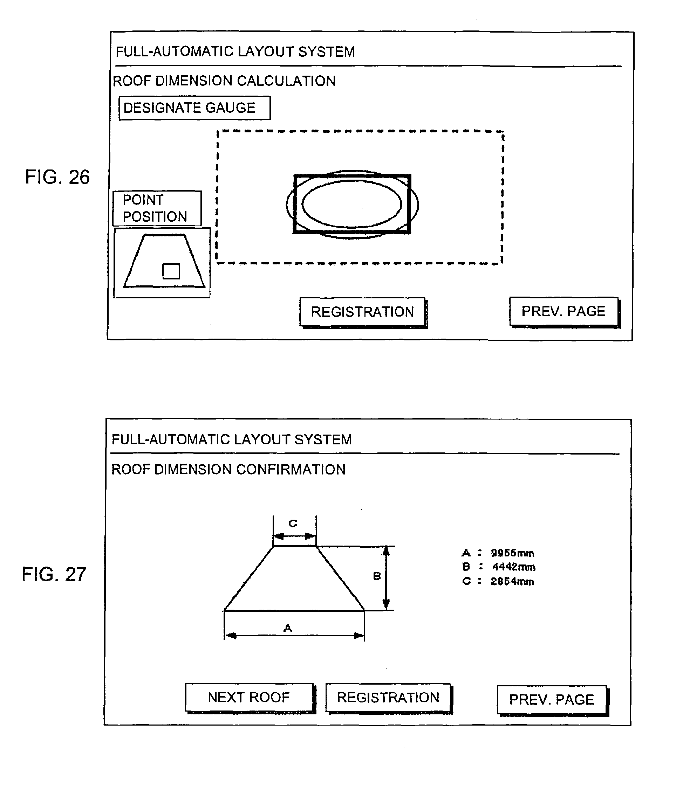

Fig. 26 shows an enlarged gauge mount portion in the roof picture of Fig. 25. Since the gauge is an important reference determining dimension accuracy, the picture is enlarged as much as possible. The gauge is designated with the mouse in accordance with the guidance of the "point position" on the screen so as to be fit in the center of the line width of the reference circle of the circle gauge (for example, yellow line shown in "color allocation for clear weather" in Fig. 2), and the registration button is clicked.
By the simple terminal operation, dimensions of the parts in the roof are automatically calculated as shown in Fig. 27. The calculating method is as described in "6. Installation Surface Shape Specifying Means". In the case of simultaneously installing a solar cell on another roof surface, a pre-captured picture is stored in a terminal, a "next roof" button is clicked, and dimensions of the roof are calculated by similar operations. On completion of acquisition of the dimensions of the roof, the registration button is clicked.

When the registration button in Fig. 27 is clicked, the screen of Fig. 8 is displayed. When a MAX button is clicked, an image is displayed in which photovoltaic modules are installed maximally in an installable range surrounded by a red line on the roof drawing in the computer screen.
By clicking the base model name displayed in the "installable base model name" box in Fig. 8, a layout corresponding to the selected base model name is displayed as shown in Fig. 9.
On the other hand, when the mouse is moved onto the photovoltaic module layout displayed on the screen of Fig. 8, a part of modules is deleted or replaced with modules of another shape, and a re-search button is clicked, the model name of the attached base corresponding to the layout deformed as shown in Fig. 10 is displayed in the installable base model name box.
The roof shapes which can be dealt by the full automatic layout system are not limited to basic shapes such as rectangle, trapezoid, parallelogram, isosceles triangle, and the like but include a special roof shape such as a rectangle with its right corner is notched in a rectangular shape.

An example of the procedure of selecting the layout of the photovoltaic modules has been described using the screen displayed on the terminal. For example, a salesperson enters customer information as input information from a visiting place in the third example to make the position of an image of the house of the customer correspond to GPS coordinates. In such a manner, information specifying the house can be transmitted from a portable terminal such as a cellular phone in the visiting place to the server.
By registering an email address for a cellular phone as customer information, information for accessing support information can be sent by email.

While the present examples have been described with respect to installation support systems and methods used before installation of a photovoltaic power generator, it goes without saying that these examples enable customers who already possess photovoltaic power generators installed on their houses to grasp the installation state. For example, as follow-up after contract and installation, it is possible to link, via a network, power generation information of systems of customers, in which the photovoltaic power generators are already installed, automatically monitor outputs of the customers, and compare or the like the outputs of the customers with the values from the power generation amount prediction means according to the present application. Also, it is possible to combine the installation support system with weather data and provide a service system capable of automatically detecting a significant drop in the output inconsistent with weather conditions and rapidly addressing to such a drop.

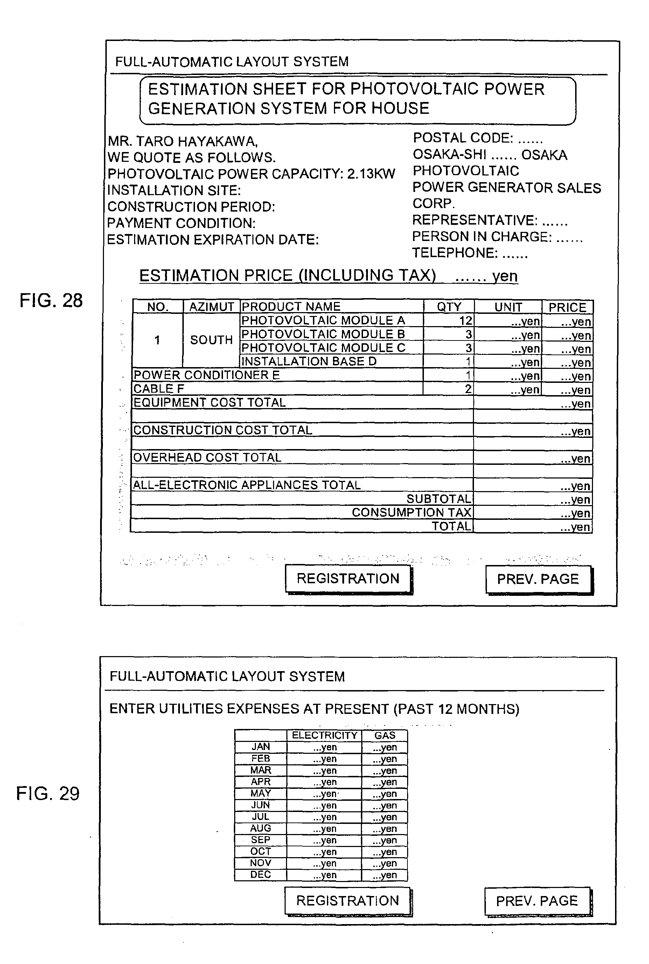

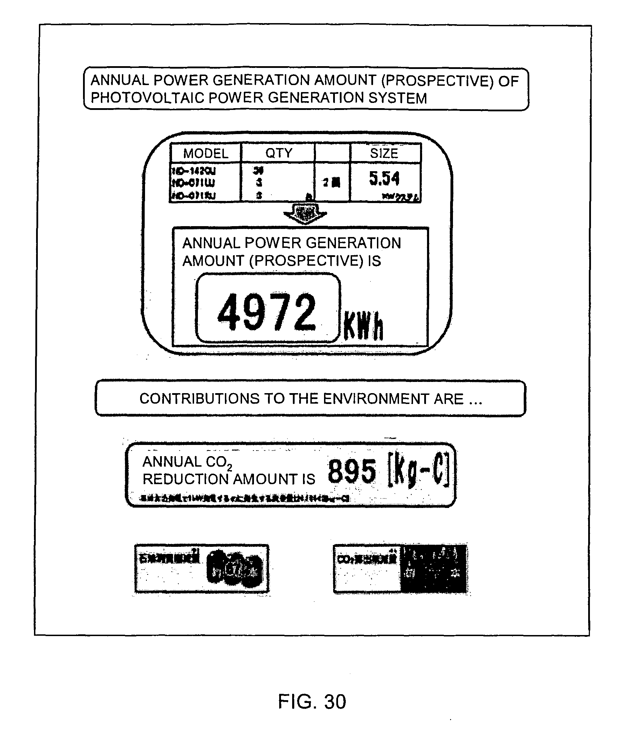

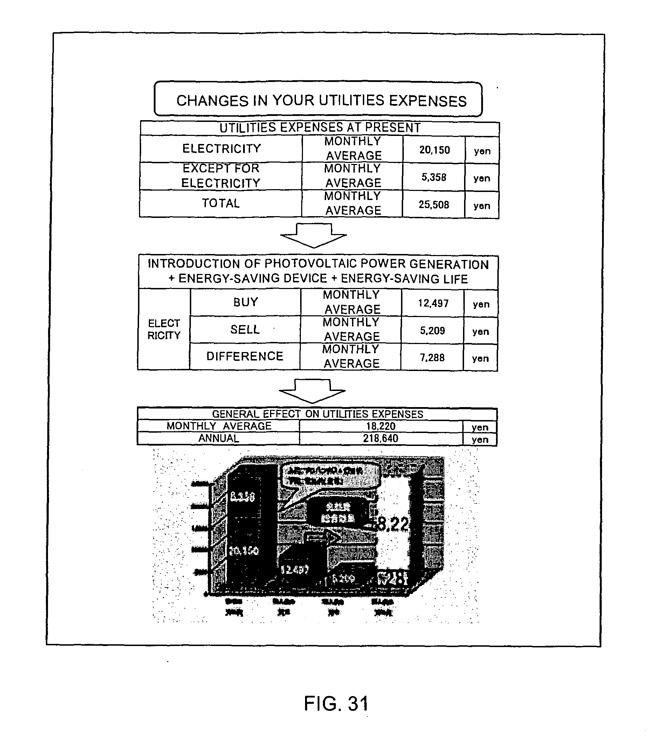

Further, when a salesperson brings a portable information terminal equipped with the internet as medium means for inputting and outputting information according to the present invention, a diagnostic for installation of a photovoltaic power generator can be performed during site-visit sales. Thus, motivation of customers for installation is further promoted.
At the time of creating an estimation sheet, as shown in Fig. 28, an estimation sheet may include not only photovoltaic products but also construction cost, all-electric appliances, and the like.
At the time of creating a proposal sheet, by accepting, for example, an entry of utilities expenses of past 12 months of the customer on a screen as shown in Fig. 29, a proposal sheet is automatically generated.
In a page subsequent to the proposal sheet as shown in Fig. 30, the degree of contribution to the environment such as the annual power generation amount of the photovoltaic power generation system, an annual CO2 reduction amount, and the like in the case of installing the photovoltaic power generation system in a customer's house are expressed in figures. Consequently, a concrete appeal can be made.
In a page next to the page subsequent to the proposal sheet, changes in prices of payment of utilities expenses after installation of the photovoltaic power generation system, a midnight-electricity-using device, and the like are displayed in prices so as to be linked with the actual capacity of the photovoltaic power generation system as shown in Fig. 31.
A concrete example of such a proposal sheet is an example and, as necessary, the format of a proposal sheet is updated as necessary.

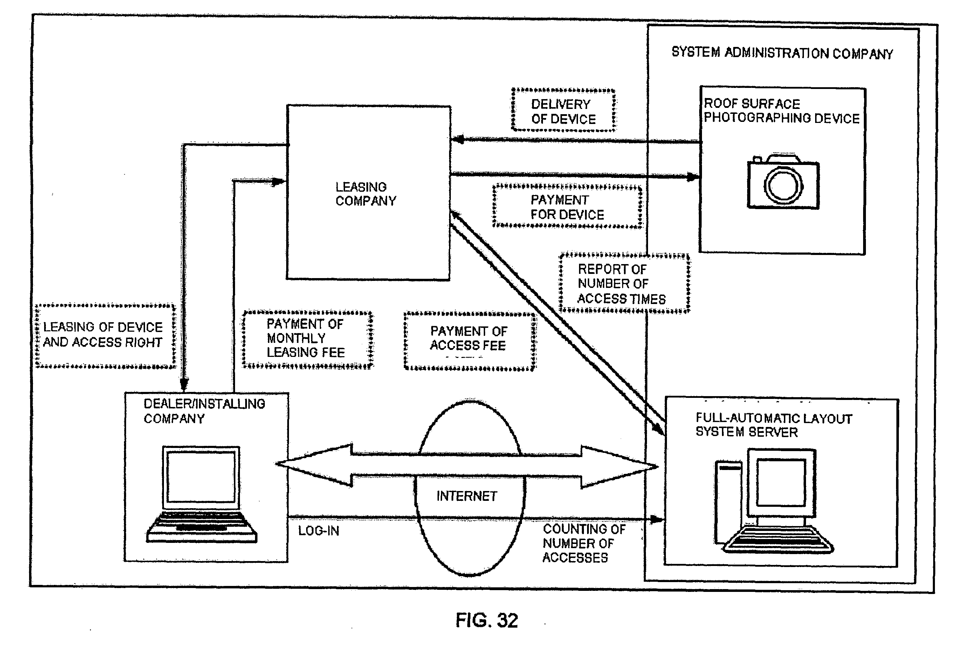

The system may be released to members on the Internet, a set of dedicated roof face photographic devices may be sold, and the server connection fee may be collected.
For example, as shown in Fig. 32, a leasing company leases an installation surface image photographic device and the access right to the system to a dealer or an installing company in exchange for leasing fee of the roof surface photographic devices and the server connection fee, and issues a registration ID and a password necessary for an access.
The leasing company receives a report on the number of accesses and the like for each of registration IDs from the system administrator, and pays a part or all the server connection fee to the system administrator. The leasing company and the dealer may have a contract of leasing or bullet payment.

As long as the fact of an access using a registered ID can be recognized, the leasing company may automatically collect a fixed amount of money including the server using fee every month. In this case, it is possible to determine whether the access lies in the sales range of the dealer or not and recognize the fact of an access on the basis of information of position detection means. It is also possible to determine the fact of an access by determining whether the access lies in the sales range of the dealer or not on the basis of information of the address or the like of the installation site accompanying installation surface image data.
It is also possible to determine the fact of an access by determining whether the access lies in the sales range of a dealer or not on the basis of dealer information accompanying the installation surface image data. In this case, preferably, the dealer information is added to the installation surface image data at the time of performing photographing by the leased photographic devices.

As described above, a person without special knowledge on the photovoltaic power generation system can also measure the dimensions of a roof safely and easily. Arrangement of the photovoltaic modules installable on the roof can be performed automatically. A power converter optimum to the power generation capacity is automatically selected, and an estimate sheet and a proposal sheet are automatically generated. Thus, anyone can prepare concrete system introduction.
A dealer can use the system at low cost by making a contract with a leasing company so that it can dedicate in sales activities of the photovoltaic power generation system and obtain the latest information of an effort of improving the environment and the like, which is timely supplied from the system administrator.
The dealer can enlarge the range of sales without development in human resources and increase in the number of staffs.
The various features described in the foregoing embodiments and examples can be combined with one another. In the case where a plurality of features is included in a single embodiment, one or more features among the plurality of features may be properly extracted and used alone or in combination so as to be employed for the present invention.

## Claims

1. A support system for installing a photovoltaic power generator comprising:
display means for displaying an installation surface image including an installation surface on which photovoltaic modules are to be installed and a gauge disposed on the installation surface and whose actual dimensions are known, the installation surface being a region of a finite area;
installation surface input means for receiving inputs for specifying the installation surface on the installation surface image displayed on the display means;
installation surface shape specification means for specifying an installation surface shape on the basis of the dimensions of the gauge in the installation surface image; and
module determination means for determining a type and layout of the photovoltaic modules suitable for the installation surface shape.

2. The system of claim 1, further comprising estimation means for calculating estimated price for installation of the photovoltaic power generator on the basis of the type and layout of the modules determined by the module determination means.

3. The system of claim 1 or 2, further comprising a placement pattern database storing plural placement patterns of the modules, wherein the module determination means makes a comparison between the respective placement patterns in the placement pattern database and the installation surface shape and selects a placement pattern suitable for the installation surface shape to determine the layout.

4. The system of claim 1 or 2, further comprising a module information database storing shapes of the modules, wherein the module determination means calculates a maximum area capable of mounting the modules thereon from the installation surface shape and determines the type and layout of the modules from the maximum area and the shapes of modules read from the module information database.

5. The system of claim 1 or 2, further comprising:
a module information database storing specifications about power generation performance of the modules;
a solar amount information database storing measurement points and
monthly-mean day-accumulated slope solar-radiation-amount data in a slope at each of the points; and
power generation amount prediction means for calculating prospective power generation amount, from the specifications, the monthly-mean day-accumulated slope solar-radiation-amount data, and the installation surface shape.

6. The system of any one of claims 1 to 5, further comprising:
an installation support information database storing installation support information consisting of at least one of an installation price, a prospective power generation amount and a synthesized image;
data transmission means for transmitting the installation support information stored in the installation support information database to customers; and
browse means for enabling browsing of the installation support information.

7. A support program for installing a photovoltaic power generator which allows a computer to function as:
display means for displaying an installation surface image including an installation surface on which photovoltaic modules are to be installed and a gauge disposed on the installation surface and whose actual dimensions are known, the installation surface being a region of a finite area;
installation surface input means for receiving inputs for specifying the installation surface on the installation surface image displayed on the display means;
installation surface shape specification means for specifying an installation surface shape on the basis of the dimensions of the gauge in the installation surface image; and
module determination means for determining a type and layout of the photovoltaic modules suitable for the installation surface shape.

8. A support program for installing a photovoltaic power generator which allows a computer to function as:
display means for displaying an installation surface image including an installation surface on which photovoltaic modules are to be installed and a gauge disposed on the installation surface and whose actual dimensions are known, the installation surface being a region of a finite area;
installation surface input means for receiving inputs for specifying the installation surface on the installation surface image displayed on the display means;
installation surface shape specification means for specifying an installation surface shape on the basis of the dimensions of the gauge in the installation surface image;
module determination means for determining a type and layout of the photovoltaic modules suitable for the installation surface shape; and
estimation means for calculating estimated price for installation of the photovoltaic power generator on the basis of the type and layout of the modules determined by the module determination means.
